Europäisches Patentamt

European Patent Office

Office européen des brevets

(11) Numéro de publication: **0 493 269 B1**

## FASCICULE DE BREVET EUROPEEN

(45) Date de publication du fascicule du brevet: **27.09.95**

(51) Int. Cl.6: **G01N 11/00**, G01N 21/00, H01L 21/3105

(21) Numéro de dépôt: **91420414.4**

(22) Date de dépôt: **22.11.91**

(54) **Procédé de mesure de la viscosité d'un matériau.**

(30) Priorité: **29.11.90 FR 9015241**

(43) Date de publication de la demande:
**01.07.92 Bulletin 92/27**

(45) Mention de la délivrance du brevet:
**27.09.95 Bulletin 95/39**

(84) Etats contractants désignés:
**AT DE GB IT NL**

(56) Documents cités:
**FR-A- 2 603 379**

**PROCEEDINGS OF THE SPIE, vol. 1012: "In-process optical measurements", 22-23 Septembre 1988, pages 186-193; A. TISSIER et al.: "An optical method for in-line glass flow control"**

**PROCEEDINGS OF THE 17TH EUROPEAN SOLID STATE DEVICE RESEARCH CONFERENCE, Bologne, 14-17 septembre 1987, Ed. G. Soncini et al., pages 431-434, North-Holland, NL; A. TISSIER et al.: "Glass reflow modeling for process optimization"**

(73) Titulaire: **FRANCE TELECOM Etablissement autonome de droit public, 6, Place d'Alleray F-75015 Paris (FR)**

(72) Inventeur: **Tissier, Annie 10, Domaine des Plantées, Biviers F-38330 Saint Ismier (FR)** Inventeur: **Teissier, Jean-François 8, Avenue Marie Curie F-38500 Voiron (FR)**

(74) Mandataire: **de Beaumont, Michel 1bis, rue Champollion F-38000 Grenoble (FR)**

## Description

La présente invention concerne un procédé de mesure de la viscosité d'un matériau déposé en couche mince sur un substrat.

La présente invention s'applique notamment dans le domaine des circuits intégrés. Lors de la réalisation des circuits intégrés, on est amené à utiliser certains matériaux déposés en couches très minces et à modifier la forme de ces couches minces par des traitements thermiques appropriés qui font fluer le matériau. Le fluage du matériau correspond à un transfert de masse qui résulte des forces de tension superficielle, ce transfert de masse n'étant possible que si le matériau présente une certaine viscosité.

En général, les matériaux que l'on dépose en couche mince ne sont pas destinés à être portés à des températures élevées pendant un temps suffisamment long pour que l'on obtienne un fluage très important. On cherche simplement à modifier, par un certain fluage, les formes des motifs du matériau déposé, en particulier pour arrondir les angles. Lors de la fabrication de circuits intégrés, une opération de traitement thermique visant à effectuer un certain fluage d'un matériau donné ne peut être correctement menée que si l'on connaît relativement bien la viscosité du matériau à la température à laquelle on souhaite le soumettre. La connaissance de cette viscosité peut servir, en particulier, comme paramètre introduit dans les systèmes de modélisation qui sont constitués par des logiciels permettant de prédire le comportement et l'agencement de microstructures, sans avoir recours à un grand nombre d'expérimentations réelles. Il peut être intéressant de connaître aussi, de façon très précise, la viscosité d'un matériau donné, à une température donnée, pour toute autre raison que celle évoquée ci-dessus.

Les matériaux en couches minces ne correspondent pas parfaitement, en structure et en composition chimique, aux mêmes matériaux produits en grande quantité. On ne peut par conséquent pas déduire de la mesure de la viscosité d'un matériau effectuée par des moyens classiques la viscosité de ce matériau déposé en couche mince.

On rappellera que la mesure de viscosité selon les procédés classiques consiste à disposer une certaine quantité de matériau dans un réservoir muni d'un orifice et à mesurer la vitesse d'écoulement de ce matériau à travers l'orifice.

Le brevet US-A-4813781 enseigne que l'on peut mesurer le degré de fluage d'un matériau déposé en couche mince en formant sur un substrat un réseau de bandes parallèles dudit matériau, de telle sorte que ces bandes parallèles constituent un réseau de diffraction, en soumettant le réseau aux conditions dans laquelle le matériau flue, en éclairant le réseau par un faisceau lumineux monochromatique et en observant l'évolution de la lumière diffractée au cours du fluage. En particulier, on mesure l'intensité d'au moins une tache lumineuse de l'image diffractée et on en déduit un certain niveau de déformation des bandes du réseau et, par là, un certain degré de fluage du matériau.

Ce procédé permet de comparer un niveau de fluage d'un matériau par rapport à un même niveau de fluage du même matériau obtenu antérieurement et ayant donné satisfaction. Toutefois, ce procédé n'est pas de nature à permettre une mesure quantitative des déplacements de matières et, en conséquence, ne permet pas de déterminer, pour des conditions données, l'indice de viscosité d'un matériau.

Un objet de la présente invention est de prévoir un procédé de mesure de viscosité d'un matériau en couche mince qui soit simple et fiable.

Pour atteindre cet objet, la présente invention prévoit un procédé de mesure de la viscosité d'un matériau consistant à former un réseau de bandes parallèles dudit matériau pour constituer un réseau de diffraction ; éclairer le réseau par un faisceau lumineux monochromatique dont la lumière diffractée produit une figure de diffraction composée d'une tache lumineuse principale correspondant à la réflexion spéculaire et d'une multitude de taches adjacentes alignées de diffraction dont l'enveloppe présente un lobe principal incluant la tache principale et des lobes secondaires parmi lesquels le premier lobe est adjacent au lobe principal ; soumettre le réseau à un traitement thermique consistant à le porter rapidement à une température prédéterminée et à le maintenir à cette température ; sélectionner la tache la plus brillante parmi celles du premier lobe et mesurer l'évolution de l'intensité lumineuse de cette tache au cours du traitement thermique ; déterminer l'intervalle de temps d s'écoulant jusqu'au premier passage par une valeur minimum de l'intensité de ladite tache ; et en déduire la valeur $v$ de la viscosité du matériau constituant le réseau par la formule $1/v = \alpha d$, où $\alpha$ est une constante déterminée par un étalonnage de l'appareil avec un matériau connu.

De préférence, les bandes parallèles du réseau de diffraction sont régulièrement espacées et présente chacune une section transversale en forme de rectangle de largeur $\ell$ et d'épaisseur e, et sont distantes d'un pas p, le faisceau lumineux a une longueur d'onde $\lambda$. Les valeurs $\ell$, e, et $\lambda$ répondent aux critères suivants :

$$1\mu m < \ell < 60\mu m$$
$$0,1\mu m < e < 6\mu m$$
$$0,2\mu m < \lambda < 10\mu m,$$

et le rapport p/ℓ est tel que le nombre de taches du premier lobe soit supérieur à 4.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1 représente schématiquement, en coupe transversale, un réseau de diffraction utilisé pour la mise en oeuvre du procédé selon la présente invention ;

la figure 2 représente schématiquement, en coupe transversale, une des bandes parallèles constituant le réseau de diffraction représenté en figure 1 ;

la figure 3 représente schématiquement, en coupe transversale, le même élément que celui de la figure 2 ayant subi un fluage ;

les figures 4A, 4B et 4C représentent le diagramme de diffraction obtenu en mettant en oeuvre le procédé selon l'invention, au cours de trois stades successifs de fluage du matériau ; et

la figure 5 est une courbe représentant la relation entre le degré de fluage et le paramètre HL1 utilisé dans le procédé selon la présente invention.

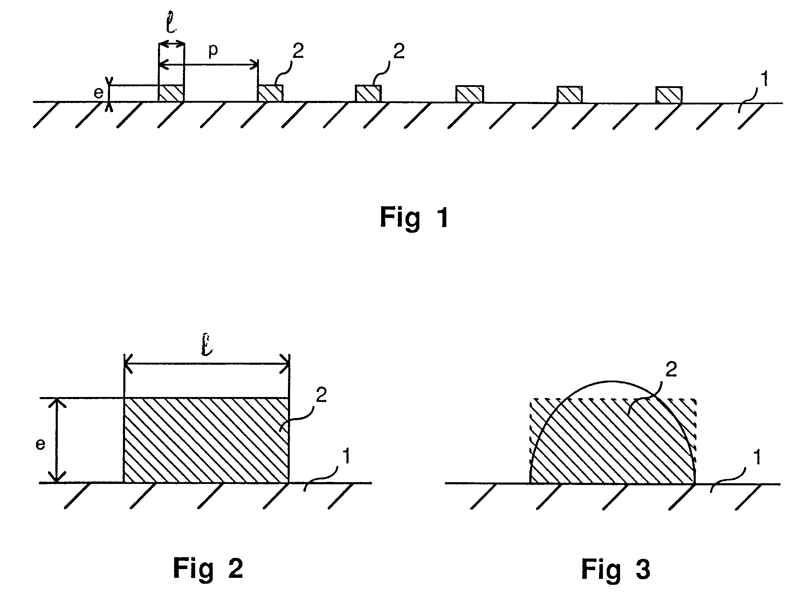

Le procédé de mesure de la viscosité selon la présente invention fait appel, tout d'abord, à l'élaboration sur une plaquette 1 d'un réseau de diffraction constitué d'un ensemble de bandes parallèles 2 régulièrement espacées, réalisées dans le matériau dont on souhaite mesurer la viscosité à une température donnée T. La section transversale de chaque bande 2 présente une forme rectangulaire, comme cela est représenté en figure 2.

Si l'on porte la plaquette 1, et par conséquent les bandes parallèles 2, à une certaine température T, la viscosité du matériau à cette température T devient suffisamment faible pour que les forces résultant de la tension superficielle provoquent une déformation des bandes parallèles 2.

La figure 3 représente une bande parallèle 2 ayant subi un certain fluage. On voit que les formes se sont arrondies. Si, à la température T, la viscosité est extrêmement faible ou si, ce qui revient au même, on porte l'échantillon à cette température pendant un temps très long, la forme intiale rectangulaire (figure 2) tend à devenir une forme sphérique aplatie qui correspond à la forme que prend une goutte d'eau sur une surface plane.

Selon la présente invention, on soumet le réseau de diffraction constitué des bandes parallèles 2 à un traitement thermique consistant à porter rapidement le réseau de diffraction à une température prédéterminée T. Au cours de ce traitement thermique, on éclaire le réseau de diffraction par un faisceau lumineux monochromatique présentant une longueur d'onde correspondant au domaine du visible, de l'ultraviolet ou de l'infrarouge.

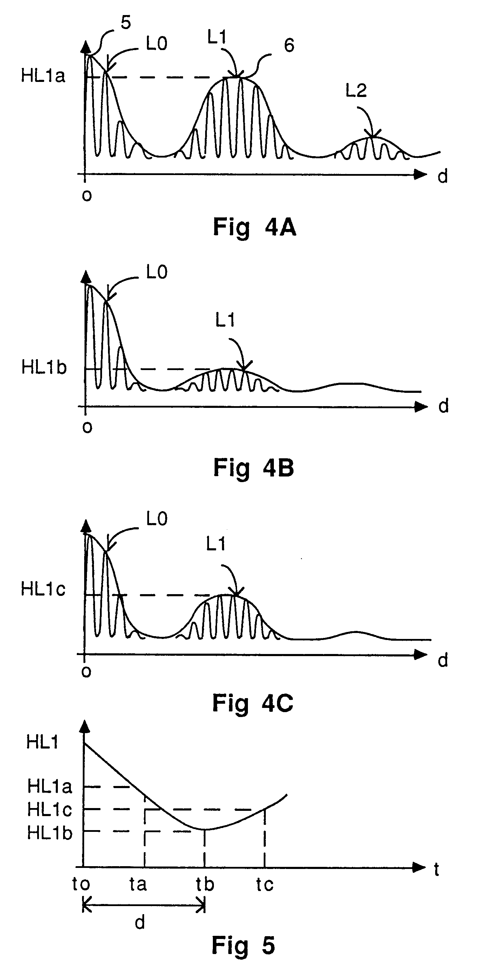

La lumière diffractée produit une figure de diffraction dont un exemple est représenté en figure 4A. Cette figure de diffraction est composée d'une tache lumineuse principale 5 correspondant à la réflexion spéculaire et d'une multitude de taches adjacentes alignées de diffraction dont l'enveloppe présente un lobe principal L0 incluant la tache principale 5 et des lobes secondaire L1, L2, etc., parmi lesquels le premier lobe L1 est adjacent au lobe principal L0. Dans la figure 4A, on n'a en fait représenté qu'une moitié de la figure de diffraction puisqu'elle est symétrique par rapport au plan spéculaire.

La demanderesse a étudié cette figure de diffraction et son évolution lors du fluage qui se produit continuement lorsque l'échantillon est porté à la température constante T, afin de proposer un procédé faible et reproductible de mesure de la valeur réelle de la viscosité du matériau à la température T.

Selon la présente invention, on sélectionne la tache 6 la plus brillante parmi celles du premier lobe L1 et on mesure l'évolution de l'intensité lumineuse HL1 de cette tache 6 au cours du traitement thermique. Lorsque l'on commence le traitement thermique de l'échantillon, à l'instant t0, on obtient une certaine figure de diffraction, on attend un certain temps et, à un instant ta, on obtient une autre figure de diffraction correspondant à la figure 4A. A un instant tb ultérieur, on obtient une autre figure de diffraction correspondant à la figure 4B et à un instant tc encore ultérieur, on obtient une figure de diffraction correspondant à la figure 4C. En fait, l'allure de la figure de diffraction reste sensiblement la même au cours du fluage progressif de l'échantillon, mais la demanderesse a remarqué que l'intensité lumineuse HL1 de la tache 6 la plus brillante du premier lobe L1 varie de façon relativement importante en fonction de l'évolution du fluage du réseau au cours du traitement thermique.

Dans la figure 5, on voit l'évolution de l'intensité lumineuse HL1 de la tache 6 au cours du fluage. A l'instant ta, l'intensité lumineuse de la tache 6 a une valeur relativement grande HL1a ; à l'instant suivant tb, elle prend une valeur HL1b nettement inférieure ; et à l'instant tc ultérieur on voit que la valeur HL1c est à nouveau supérieure à la valeur HL1b.

Ainsi, la demanderesse a noté que, au cours du fluage, l'intensité lumineuse HL1 de la tache 6 commence par décroître, passe par un minimum HL1b puis croît à nouveau. Or, il est très facile de repérer visuellement ou par des appareils automatiques l'instant où la valeur d'une intensité lumineuse passe par un minimum.

Ce passage par un minimum est spécifique de la raie la plus brillante du premier lobe et peut être associé de façon univoque à un état de déformation des bandes du réseau de diffraction. En conséquence, l'intervalle de temps d qui s'est écoulé entre l'instant $t_0$ de début du traitement thermique et l'instant $t_b$ est une grandeur physique représentative de la valeur de la viscosité du matériau constituant le réseau de diffraction à la température T à laquelle ce réseau est porté. En fait, cet intervalle de temps d est proportionnel à l'inverse de la valeur de la viscosité, le coefficient de proportionnalité pouvant être déterminé par un étalonnage préalable effectué avec un matériau dont la viscosité en couche mince est connue.

Lorsque l'on met en oeuvre le procédé de mesure de viscosité selon l'invention pour la première fois sur un équipement donné, il convient d'opérer tout d'abord à son étalonnage en réalisant un premier réseau dans un matériau dont on connaît par avance la viscosité $v_0$ et en effectuant, comme cela a été décrit précédemment, la mesure de l'intervalle de temps $d_0$ écoulé entre l'instant $t_0$ du début du traitement thermique et l'instant $t_b$. On détermine alors une constante $\alpha$ à partir de la formule suivante :

$$1/v_0 = \alpha d_0,$$

La mesure de viscosité que l'on effectue ensuite se fait à partir d'un réseau de diffraction 2 de forme géométrique et de dimensions en tous points identiques au premier réseau mais réalisé dans le matériau dont on veut mesurer la viscosité. On effectue sur ce réseau la mesure de l'intervalle de temps d et on en déduit l'indice de viscosité $v$ par la formule suivante :

$$1/v = \alpha d,$$

le coefficient $\alpha$ ayant été déterminé au préalable de la façon indiquée ci-dessus.

Selon un autre aspect de la présente invention, le réseau de diffraction doit respecter certaines conditions dimensionnelles pour que le procédé de mesure de viscosité précédemment décrit permette une détermination fiable et reproductible de la valeur de la viscosité du matériau. On se reportera aux figures 1 et 2 pour expliciter ces conditions. Chaque bande parallèle 2 présente une section transversale de forme rectangulaire de largeur $\ell$ et d'épaisseur e. On définit aussi par p le pas du réseau, c'est-à-dire la distance séparant chaque bord latéral correspondant de deux bandes parallèles 2 adjacentes. Le faisceau lumineux monochromatique utilise une lumière de longueur d'onde $\lambda$.

Pour la longueur d'onde $\lambda$ choisie, il convient de choisir des valeurs de $\ell$ et de e qui soient telles que la figure de diffraction obtenue présente un premier lobe L1 suffisamment important et que l'intensité lumineuse HL1 varie effectivement, en fonction du fluage, en passant par un minimum pour un instant précis $t_a$. Il convient aussi de choisir une valeur de e correspondant à l'ordre de grandeur de l'épaisseur des couches que l'on envisage de réaliser ensuite avec le matériau dont on veut mesurer la viscosité.

Ainsi, selon un mode particulier de l'invention, pour une longueur d'onde $\lambda$ comprise entre 10 et 0,2 $\mu m$, les valeurs $\ell$ et e répondent aux critères suivants :

$$1\mu m < \ell < 60\mu m$$
$$0,1\mu m < e < 6\mu m$$

Toujours pour la longueur d'onde $\lambda$ choisie, il convient aussi de choisir un rapport $p/\ell$ tel que le nombre des taches du premier lobe L1 de la figure de diffraction soit supérieure à 4.

Certains matériaux dont on veut mesurer la viscosité ne peuvent pas être gravés facilement. Dans ce cas, il apparaît trop difficile ou impossible de réaliser avec de tels matériaux un réseau de diffraction satisfaisant. Pour surmonter cette difficulté, on réalise sur un substrat plan un réseau de diffraction semblable à celui décrit précédemment mais réalisé en un matériau que l'on sait bien graver et qui ne fluera pas ou très peu à la température de mesure T. Ensuite, on dépose sur ce réseau une couche mince du matériau que l'on veut analyser. Cette couche épouse alors la forme du réseau sous-jacent et constitue elle-même, le réseau de diffraction utilisé pour la mesure de la viscosité selon l'invention.

## Revendications

1. Procédé de mesure de la vicosité d'un matériau consistant à :
   - former un réseau de bandes parallèles (2) dudit matériau pour constituer un réseau de diffraction ;
   - éclairer le réseau par un faisceau lumineux monochromatique dont la lumière diffractée produit une figure de diffraction composée d'une tache lumineuse principale (5) correspondant à la réflexion spéculaire et d'une multitude de taches adjacentes alignées de diffraction dont l'enveloppe présente un lobe principal (L0) incluant la tache principale (5) et des lobes secondaires (L1, L2) parmi lesquels le premier lobe (L1) est adjacent au lobe principal (L0) ;

caractérisé en ce qu'il comprend les étapes suivantes :
- soumettre le réseau à un traitement thermique consistant à le porter rapidement à une température prédéterminée (T) et à le maintenir à cette température ;
- sélectionner la tache (6) la plus brillante parmi celles du premier lobe (L1) et mesurer l'évolution de l'intensité lumineuse (HL1) de cette tache (6) au cours du traitement thermique ;
- déterminer l'intervalle de temps (d) s'écoulant jusqu'au premier passage par un valeur minimum de l'intensité (HL1b) de ladite tache (6) ; et
- en déduire la valeur ($v$) de la viscosité du matériau constituant le réseau par la formule $1/v = \alpha d$, où $\alpha$ est une constante déterminée par un étalonnage de l'appareil avec un matériau connu.

2. Procédé de mesure de la viscosité d'un matériau selon la revendication 1, dans lequel les bandes parallèles (2) du réseau de diffraction sont régulièrement espacées et présentent chacune une section transversale en forme de rectangle de largeur ℓ et d'épaisseur e, et sont distantes d'un pas p, et dans lequel le faisceau lumineux a une longueur d'onde λ et les valeurs ℓ, e, et λ répondent aux critères suivants :

$$1\mu m < \ell < 60\mu m$$
$$0,1\mu m < e < 6\mu m$$
$$0,2\mu m < \lambda < 10\mu m,$$

et le rapport p/ℓ est tel que le nombre de taches du premier lobe (L1) soit supérieur à 4.

## Claims

1. A method for measuring the viscosity of a material comprising:
- forming an array of parallel strips (2) of said material for constituting a diffraction grating;
- illuminating the array with a monochromatic light beam, the diffracted light of which produces a diffraction pattern comprised of a main light spot (5) corresponding to the specular reflection and of a plurality of adjacent, aligned, diffraction spots, the envelope of which exhibits a major lobe (L0) including said main spot (5) and minor lobes (L1, L2) among which said first lobe (L1) is adjacent to said major lobe (L0);
characterized in that it comprises the following steps:
- subjecting said array to a thermal process consisting of rapidly heating it at a predetermined temperature (T) and maintaining it at said temperature;
- selecting the brightest spot (6) among those of said first lobe (L1) and measuring the evolution of the light intensity (HL1) of said spot (6) during the thermal process;
- determining the time interval (d) elapsing until the first passage by a minimum intensity value (HL1b) of said spot (6); and
- deducing therefrom the value ($v$) of the viscosity of the material constituting the array by the formula $1/v = \alpha d$, where $\alpha$ is a constant determined by calibration of the apparatus with a known material.

2. A method for measuring the viscosity of a material according to claim 1, wherein the parallel strips (2) of the diffraction grating are regularly spaced, each exhibiting a cross section in the form of a rectangle having a width ℓ and a thickness e, and are separated by a pitch p, and wherein the light beam has a wavelength λ, and the values ℓ, e and λ meet the following criteria:

$$1 \mu m < \ell < 60 \mu m$$
$$0.1 \mu m < e < 6 \mu m$$
$$0.2 \mu m < \lambda < 10 \mu m,$$

and wherein the ratio p/ℓ is such that the number of spots of said first lobe (L1) is higher than 4.

## Patentansprüche

1. Verfahren zum Messen der Viskosität eines Materials, das folgendes aufweist:
- Bilden bzw. Formen einer Anordnung von parallelen Streifen (2) des Materials zum Aufbau eines Beugungsgitters;
- Beleuchten der Anordnung mit einem monochromatischen Lichtstrahl, dessen gebeugtes Licht ein Beugungsmuster bzw. -bild oder -gitter erzeugt, das einen Hauptlichtfleck (5) entsprechend der spekulären Reflexion und eine Vielzahl von benachbarten, ausgerichteten Beugungsflecken aufweist, deren Einhüllende ein Hauptmaximum (L0), das den Hauptfleck (5) umfaßt und Nebenmaxima (L1, L2) aufweist, von denen das erste Maximum (L1) benachbart zu dem Hauptmaximum (L0) ist;

dadurch **gekenzeichnet,** daß es die folgenden Schritte aufweist:

- Unterwerfen der Anordnung einem thermischen Prozeß, der aus schnellem Erwärmen von diesem auf eine vorbestimmte Temperatur (T) und Halten von diesem bei der Temperatur besteht;
- Auswählen des hellsten Flecks (6) unter denen des ersten Maximums (L1) und Messen der Entwicklung der Lichtintensität (HL1) des Flecks (6) während des thermischen Prozesses;
- Bestimmen des Zeitintervalls (d), das vergeht, bis zum ersten Durchlaß bzw. Durchgang durch einen Minimumintensitätswert (HL1b) des Flecks (6); und
- Her- bzw. Ableiten daraus des Werts ($\nu$) der Viskosität des Materials, das die Anordnung aufbaut, und zwar durch die Formel $1/\nu = \alpha d$, wobei $\alpha$ eine Konstante ist, die durch die Kalibrierung der Vorrichtung mit einem bekannten Material bestimmt wird.

2. Verfahren zum Messen der Viskosität eines Materials gemäß Anspruch 1, wobei die parallelen Streifen (2) des Beugungsgitters regelmäßig beabstandet sind, wobei jeder einen Querschnitt in der Forme eines Rechtecks mit einer Breite l und einer Dicke e besitzt, und die durch einen Gang bzw. eine Periode p getrennt sind, und wobei der Lichtstrahl eine Wellenlänge $\lambda$ besitzt, und wobei die Werte l, e und $\lambda$ die folgenden Kriterien erfüllen:

$$1 \ \mu m < l < 60 \ \mu m$$
$$0,1 \ \mu m < e < 6 \ \mu m$$
$$0,2 \ \mu m < \lambda < 10 \ \mu m,$$

und wobei das Verhältnis p/l derart ist, so daß die Anzahl der Flecke des ersten Maximums (L1) größer als 4 ist.

**Fig 1**

**Fig 2**

**Fig 3**

EP 0 493 269 B1

Fig 4A

Fig 4B

Fig 4C

Fig 5